# EUROPEAN PATENT APPLICATION

(11) **EP 4 520 850 A1**
(43) Date of publication of application: **12.03.2025**
(21) Application number: 24198952.4
(22) Date of filing: 06.09.2024
(51) Int. Cl.: C23C 4/11, C23C 4/134, C23C 4/18, C23C 14/08, C23C 14/30, C23C 16/40, C23C 16/455, C23C 28/04, C23C 28/00, F01D 5/28

(54) **RARE EARTH-PHOSPHATE-ENHANCED THERMAL BARRIER COATING**

(30) Priority: 11.09.2023 US 202318244694
(71) Applicant: RTX Corporation, Farmington, CT 06032 (US)
(72) Inventor: SUDRE, Olivier H., Glastonbury, 06073 (US)
(74) Representative: Dehns

(57) **Abstract**

A component having a thermal barrier coating (22) having a substrate surface of the component; a thermal barrier coating (22) on the substrate surface, the thermal barrier coating (22) having a coating surface and coating surface accessible spaces (24); and a layer (26) of rare-earth phosphate on surfaces of the coating surface accessible spaces (24). The spaces (24) can be intercolumnar spaces (24) between columns (20) or feathers of the thermal barrier coating (22). A method is also disclosed.

## Description

### BACKGROUND OF THE DISCLOSURE

The disclosure relates to thermal barrier coatings and application of thermal barrier coatings with protection from attack by calcium magnesium aluminosilicate (CMAS).

Gas turbine engines, for example for powering aircraft, operate at high temperatures. Components of these and other devices, engines or machines are therefore frequently protected from high temperatures by thermal barrier coatings. Such coatings themselves, however, can be subject to various environmental issues, one of which is attack by calcium magnesium aluminosilicate (CMAS). At high temperatures such as those experienced during operation of a gas turbine engine, molten CMAS can attack the thermal barrier coating and cause early spalling or other degradation of the coating.

A typical thermal barrier coating, for example a yttria stabilized zirconia (YSZ) or Gd₂Zr₂O₇ coating, is typically formed in a columnar structure, for example formed using electron beam physical vapor deposition (EB-PVD). This columnar structure is useful for managing the strain differential between the coating and the underlying substrate. This columnar structure, however, is relatively easily penetrated by molten CMAS, which then bonds the columns together and leads to failure of the now monolithic coating. Other applications of thermal barrier coatings, such as but not limited to plasma spray, also form coatings that have pores, cracks or both. These pores and cracks can also be invaded by CMAS which can harden and produce a monolithic coating.

### SUMMARY OF THE DISCLOSURE

The disclosure relates to a thermal barrier coating that is enhanced with rare earth-phosphate to help prevent attack by CMAS.

In one non-limiting configuration, a component having a thermal barrier coating comprises a substrate surface of the component; a thermal barrier coating on the substrate surface, the thermal barrier coating having a coating surface and coating surface accessible spaces; and a layer of rare-earth phosphate on surfaces of the coating surface accessible spaces.

In another non-limiting configuration, the coating surface accessible spaces are defined by a columnar structure of the coating, wherein columns of the columnar structure define intercolumnar spaces, and wherein the layer of rare-earth phosphate is on surfaces of the intercolumnar spaces.

In still another non-limiting configuration, the layer has less porosity than the thermal barrier coating.

In a further non-limiting configuration, the rare-earth phosphate is non-wetting/non-bonding to material of the thermal barrier coating.

In a still further non-limiting configuration, the material contains oxides selected from the group consisting of Al₂O₃, ZrO₂, Gd₂Zr₂O₇ and combinations thereof.

In another non-limiting configuration, the layer of rare-earth phosphate has a thickness of between 1 nm and 10 µm.

In still another non-limiting configuration, the coating surface accessible spaces extend substantially to the substrate surface, and wherein the layer extends substantially the entire length of the surfaces of the coating surface accessible spaces.

In a further non-limiting configuration, the layer is within 5% atomic of stoichiometric balance.

In a still further non-limiting configuration, the rare earth phosphate comprises lanthanum phosphate.

In another embodiment, a method for coating a substrate, comprises the steps of: applying a thermal barrier coating to a surface of the substrate, wherein the thermal barrier coating has coating surface accessible spaces; and applying a layer of rare-earth phosphate to surfaces of the coating surface accessible spaces.

In a non-limiting configuration, the thermal barrier coating is defined by a plurality of columns, and the surface accessible spaces are defined by intercolumnar spaces between the plurality of columns.

In another non-limiting configuration, the applying step comprises applying the layer of the rare-earth phosphate to the surfaces by atomic layer deposition.

In still another non-limiting configuration, the atomic layer deposition results in a layer that is within 5% atomic of balanced stoichiometry.

In a further non-limiting configuration, the layer has a lower porosity than material of the thermal barrier coating.

In a still further non-limiting configuration, the layer has a thickness of between 1 nm and 10 µm.

In another non-limiting configuration, the component is a gas turbine engine component.

In still another non-limiting configuration, the layer is deposited along substantially an entire length of the surfaces.

In a further non-limiting configuration, the thermal barrier coating comprises a material that is non-wetting/non-bonding to the rare-earth phosphate.

In a still further non-limiting configuration, the material contains oxides selected from the group consisting of Al₂O₃, ZrO₂, Gd₂Zr₂O₇ and combinations thereof.

In another non-limiting configuration, the rare earth phosphate comprises lanthanum phosphate.

Various embodiments are disclosed herein, each of which can be combined with all others except as noted herein, and each of which can be a standalone feature without requiring other aspects disclosed herein except as noted herein.

### BRIEF DESCRIPTION OF THE DRAWINGS

A detailed description of preferred embodiments follows, with referenced to the attached drawings, wherein:
FIG. 1 is a micrograph showing a thermal barrier coating;
FIG. 2 is a magnified view of a portion of FIG. 12 and shows the columnar structure of the thermal barrier coating; and
FIG. 3 is a micrograph similar to FIG. 2, but showing a thermal barrier coating enhanced with a rare-earth-phosphate layer as disclosed herein.

### DETAILED DESCRIPTION

The present disclosure relates to thermal barrier coatings for industrial machines such as gas turbine engines, for example for aircraft application. Components of such machines operate under potentially very high temperatures, and therefore such components are frequently protected with thermal barrier coatings, or TBCs. TBCs can be applied in numerous ways, one of which is by electron beam physical vapor deposition (EB-PVD). With this application, the resulting coating is typically a columnar structure with columns or feathers that have thin spaces between them. These spaces are referred to herein as intercolumnar spaces, and these spaces are useful as they allow movement of the individual columns or feathers so that the coating is tolerant to strain, for example from mismatch with the underlying substrate. TBCs can be applied in other manners as well, for example using plasma spray as another non-limiting example. Coatings applied with plasma spray may have a different structure but still have pores and cracks that can function similarly to the intercolumnar spaces of the EB-PVD coatings.

Typical materials for such thermal barrier coatings include yttrium stabilized zirconium (YSZ), Gd₂Zr₂O₇ and the like, and combinations thereof. Other non-limiting examples include plasma-spray-based TBCs that can be prepared with 7 wt. % yttria, and partially stabilized zirconia deposited by air plasma spray (APS), for example on an APS MCoCrAlY bond coat, where M is Ni, Co or combinations of Ni and Co. Another useful coating incorporates low-pressure chamber plasma-sprayed MCoCrAlY as a bond coat, where M is Ni, Co or combinations of Ni and Co.

Materials for the thermal barrier coating may comprise, in addition to the above, any of the following additional non-limiting examples of materials: zirconia, yttria stabilized zirconia (and also dysprosia, calcia or magnesia stabilized zirconia), gadolinium zirconate, hafnium oxide, gadolinium hafnate, aluminum oxide, mullite, and rare earth silicates and disilicates. Other materials are known to those skilled in the art.

Strain-tolerant ceramic top layer or TBCs applied using electron beam/physical vapor deposition (EB-PVD) processing as discussed above have excellent properties in strain tolerance. This type of TBC has demonstrated exceptional performance on rotating airfoils in high-thrust-rated engines, improving blade durability through elimination of blade creep, fracture, and rumpling of metallic coatings used for oxidation protection of the airfoil surfaces. TBCs applied using plasma-spray have also been evaluated for the accumulation of compressive stresses during cyclic thermal exposure. It should be appreciated that these coatings, as well as others applied with different methods and/or of different materials, could also be the focus of the further treatments disclosed herein.

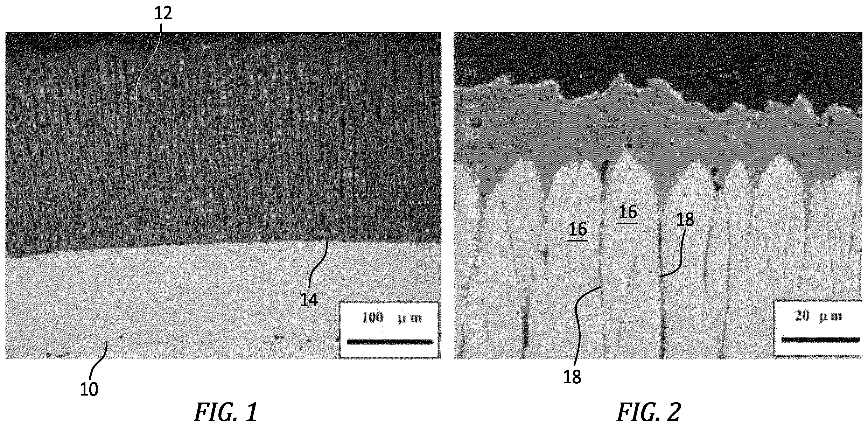

FIGS. 1 and 2 illustrate TBCs applied with EB-PVD resulting in the columnar structure as shown in FIGS. 1 and 2.

FIG. 1 shows a substrate 10 such as any of numerous components of a gas turbine engine, non-limiting examples of which include combustor surfaces, blades, vanes and the like. These components can be made from any of numerous alloys as called for by the application or environment of use of the component, one non-limiting example of which is nickel-based superalloys. As operating temperatures are pushed higher to produce more efficient operation, the components need to be protected from such high temperature and other operating conditions. For this reason, thermal barrier coatings are applied to the component, and FIG. 1 shows a typical thermal barrier coating 12 on a surface 14 of substrate or component 10.

Thermal barrier coatings can be applied using various techniques, but one method that is frequently used is electron beam physical vapor deposition, or EB-PVD. With appropriate TBC materials, this leads to a coating defined by columns or feathers extending up from surface 14 of substrate 10.

Referring to the magnified view of FIG. 2, these columns 16 can readily be seen. Adjacent columns 16 are separated by a gap or space that is referred to herein as an intercolumnar space 18. Spaces 18 allow relative movement of columns 16 with respect to each other and help the coating resist strain differential between the coating and the substrate. Allowing movement of the columns 16 relative to each other, for example to spread and contract along the intercolumnar space 18, therefore helps to provide a long useful lifetime to the coating 12.

In coatings applied using other methods, the coating may not result with a columnar structure, but a structure with cracks and pores. This can be typical of plasma sprayed coatings. In this situation, the cracks and pores can provide similar strain tolerance to the coating.

In a gas turbine engine environment, coating 12 is susceptible to attack from CMAS, especially molten CMAS that can penetrate into the area of the spaces 18 (or corresponding cracks and pores of coatings applied with other methods) and then solidify. The end result is a now-monolithic coating which is no longer well-suited to resist strain differential between the substrate and the coating. This unchecked strain differential can lead to damage to the coating, eventually resulting in spalling and other degradation.

The intercolumnar spaces, or cracks and pores, are the focus of this disclosure and will collectively be referred to as coating surface accessible spaces. As discussed further below, these coating surface accessible spaces can be accessed from the surface of the coating by materials including molten CMAS, which can lead to degradation of the coating.

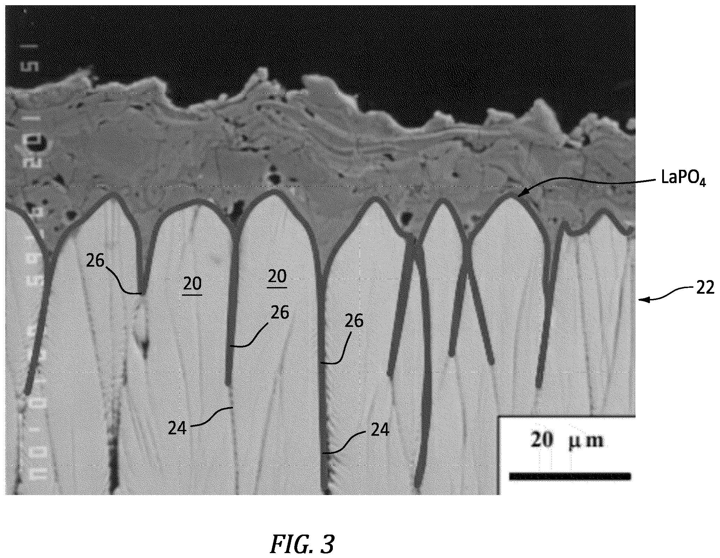

FIG. 3 shows a magnified view of columns 20 of a thermal barrier coating 22. Columns 20 are separated by gaps or spaces defining intercolumnar spaces 24 similarly to the thermal barrier coating of FIGS. 1 and 2. In this coating, however, a layer 26 of rare-earth phosphate has been applied along the side surfaces of columns 20 that define the intercolumnar spaces. The rare earth phosphate layer is non-wetting and non-bonding to other oxides such as Al₂O₃, ZrO₂, Gd₂Zr₂O₇ and the like. This serves to reduce CMAS ingress into spaces 24, and prevents CMAS from imposing a monolithic structure on the coating as discussed above. The rare earth phosphate layer as disclosed herein allows debonding of the columns 20 from each other at the intercolumnar spaces 24 so that the coating can still accommodate and be tolerant to strain. Thus, coating 26 can both prevent CMAS from entering spaces 24 and also keeps columns on either side of spaces 24 able to move to accommodate strain. It should be appreciated that this applies equally to coatings with cracks and/or pores as the coating disclosed herein would reach the coating surface accessible areas of the cracks and pores and prevent CMAS from reaching these areas similarly to the intercolumnar spaces.

In one non-limiting configuration, layer 26 of rare earth phosphate can be applied using atomic layer deposition (ALD). This method of application is advantageous because it allows layer 26 to be applied with precisely balanced stoichiometry, which has been found to help preserve the resistance or refractory nature of the layer. By application through ALD, the resulting coating can be within 5% atomic of stoichiometric balance, and in additional non-limiting configurations can further be within 2% atomic or even 1% atomic of stoichiometric balance. In a further non-limiting configuration, the rare-earth phosphate can be a line compound.

This application by ALD allows the coating or layer to be applied in a manner wherein it will have a greater density than layers applied using other methods, for example layers applied using vapor deposition and the like. This greater density can be useful in resisting infiltration of molten CMAS.

In addition, application of the rare-earth phosphate layer using ALD helps to ensure penetration of the rare-earth phosphate into substantially the entire extent of the intercolumnar space 24, or other cracks or porosity that is accessible from the surface of the coating, to ensure as complete protection as possible against bonding of columns and other portions of the coating together that can be caused by unchecked CMAS penetration.

In a typical thermal barrier coating applied using EB-PVD, there can be spacing between the columns or feathers of the material forming the coating, and the size of these spaces can be mostly on the nanometer scale, with possible wider spacing towards the surface of the coating. As one non-limiting example, the spacing can be in the range of between about 1 nm and about 10 pm, depending on location in the coating. Application of the rare-earth phosphate using ALD allows a layer of dense rare-earth phosphate to be applied having a thickness suitable to fit within the gaps between columns, or feathers, of the thermal barrier coating, for example having layer or film thicknesses in the nanometer range. Thus, as disclosed herein, layer 26 can advantageously be applied having a thickness of between 1 nm and 10 µm microns, depending on location through the thickness of the coating. Application in layers having thickness on this scale allows the rare-earth phosphate layer to reach very narrow areas of the spaces 24. Further, with coatings having cracks and porosity instead of or in addition to the spaces 24, similar sizing can occur in these cracks and open porosity, and rare-earth phosphate layers applied by ALD can substantially fill these areas and protect against molten CMAS flow.

Thermal barrier coatings that can be protected in this manner include coatings of YSZ, and Gd₂Zr₂O₇, as well as other rare-earth phosphates or other materials as indicated above. Such materials when applied using EB-PVD or other techniques will form the columns or feathers of material as illustrated in FIGS. 1 and 2, and these columns or feathers with intercolumnar spaces between them allow release of strain mismatch between the coating and substrate.

In the situation wherein the thermal barrier coating also comprises rare-earth phosphate, the ALD layer can still be distinguished from the thermal barrier layer due to at least porosity, density and stoichiometry differences between the barrier layer and the ALD layer, specifically, the ALD layer will exhibit one or more of less porosity, more density, and be closer to stoichiometric balance than the underlying TBC.

The rare earth phosphate layer may comprise any of the rare-earth phosphates such as lanthanum phosphate or lanthanum orthophosphate (monazite), other rare-earth phosphates or a combination of mixed phase rare-earth phosphates, and the like.

In another non-limiting configuration, a more complex composition to the rare-earth phosphate layer can be utilized. For example, the layer can be modified to include calcium (Ca), which itself can help to mitigate CMAS issues. Other potential additives to the rare-earth phosphate ALD layer can include but are not limited to mixed rare-earth phosphates and other more complex entropy-stabilized/high entropy/multi-principal element alloys of RE phosphate phases. Thus, as used herein, the term rare-earth phosphate includes but is not limited to such materials with other additives and can be mixed or complex rare-earth phosphates.

It should be appreciated that the rare-earth phosphate ALD layer applied as disclosed herein helps to close porosity of the TBC against infiltration by molten CMAS. Further, an essentially stoichiometric layer of rare-earth phosphate applied as disclosed using ALD results in a beneficial coating which preserves the ability of the TBC to have intercolumnar strain relief to help protect against spallation and other bad effects from strain mismatch between the substrate and the coating. As indicated, this essentially stoichiometric layer can be within 5% atomic, 2% atomic or even 1% atomic of stoichiometry.

Application of rare-earth phosphate layers to thermal barrier coatings can be usefully employed during initial coating of a part before being placed into service, and also in repair of parts and/or coatings on parts. Further, implementation of the ALD step to apply the rare-earth phosphate can be added to the production and coating of components without significant disruption.

In a repair context, the rare-earth phosphate layer or layers can be applied after repair of a TBC, over either or both of existing TBC and repaired TBC.

One or more embodiments of the present disclosure have been described. Nevertheless, it will be understood that various modifications may be made without departing from the spirit and scope of the disclosure as presented in the attached claims. Accordingly, other embodiments are within the scope of the following claims.

## Claims

1. A component having a thermal barrier coating (12; 22), comprising:
a substrate surface (14) of the component;
a thermal barrier coating (12; 22) on the substrate surface (14), the thermal barrier coating (12; 22) having a coating surface and coating surface accessible spaces (24); and
a layer (26) of rare-earth phosphate on surfaces of the coating surface accessible spaces (24).

2. The component of claim 1, wherein the coating surface accessible spaces (24) are defined by a columnar structure of the coating (12; 22), wherein columns (20) of the columnar structure define intercolumnar spaces (24), and wherein the layer (26) of rare-earth phosphate is on surfaces of the intercolumnar spaces (24).

3. The component of claim 1 or 2, wherein the rare-earth phosphate is non-wetting/non-bonding to material of the thermal barrier coating (12; 22), optionally wherein the material contains oxides selected from the group consisting of Al₂O₃, ZrO₂, Gd₂Zr₂O₇ and combinations thereof.

4. The component of any preceding claim, wherein the coating surface accessible spaces (24) extend substantially to the substrate surface (14), and wherein the layer (26) extends substantially the entire length of the surfaces of the coating surface accessible spaces (24).

5. The component of any preceding claim, wherein the layer (26) is within 5% atomic of stoichiometric balance.

6. A method for coating a substrate (10), comprising the steps of:
applying a thermal barrier coating (12; 22) to a surface (14) of the substrate (10), wherein the thermal barrier coating (12; 22) has coating surface accessible spaces (24); and
applying a layer (26) of rare-earth phosphate to surfaces of the coating surface accessible spaces (24).

7. The method of claim 6, wherein the thermal barrier coating (12; 22) is defined by a plurality of columns (20), and wherein the coating surface accessible spaces (24) are defined by intercolumnar spaces (24) between the plurality of columns (20).

8. The method of claim 6 or 7, wherein the applying step comprises applying the layer (26) of the rare-earth phosphate to the surfaces by atomic layer deposition.

9. The method of claim 8, wherein the atomic layer deposition results in a layer (26) that is within 5% atomic of balanced stoichiometry.

10. The component or method of any preceding claim, wherein the layer (26) has a lower porosity than material of the thermal barrier coating (12; 22).

11. The component or method of any preceding claim, wherein the layer (26) of rare-earth phosphate has a thickness of between 1 nm and 10 pm.

12. The method of any of claims 6 to 11, wherein the component is a gas turbine engine component.

13. The method of any of claims 6 to 12, wherein the layer (26) is deposited along substantially an entire length of the surfaces.

14. The method of any of claims 6 to 13, wherein the thermal barrier coating (12; 22) comprises a material that is non-wetting/non-bonding to the rare-earth phosphate, optionally wherein the material contains oxides selected from the group consisting of Al₂O₃, ZrO₂, Gd₂Zr₂O₇ and combinations thereof.

15. The component or method of any preceding claim, wherein the rare earth phosphate comprises lanthanum phosphate.
